# EUROPÄISCHE PATENTSCHRIFT

(11) **EP 1 274 647 B1**
(45) Veröffentlichungstag und Bekanntmachung des Hinweises auf die Patenterteilung: **08.01.2014**
(21) Anmeldenummer: 01929254.9
(22) Anmeldetag: 22.03.2001
(51) Int. Cl.: B81C 1/00

(54) **MIKROMECHANISCHES BAUELEMENT UND ENTSPRECHENDES HERSTELLUNGSVERFAHREN**
MICROMECHANICAL COMPONENT AND CORRESPONDING PRODUCTION METHOD
COMPOSANT MICROMECANIQUE ET SON PROCEDE DE PRODUCTION

(30) Priorität: 11.04.2000 DE 10017976
(43) Veröffentlichungstag der Anmeldung: 15.01.2003
(73) Patentinhaber: ROBERT BOSCH GMBH, 70442 Stuttgart (DE)
(72) Erfinder: OFFENBERG, Michael, 72138 Kirchentellinsfurt (DE); LUTZ, Markus, Sunnyvale, CA 94086 (US)
(86) Internationale Anmeldenummer: PCT/DE2001/001116
(87) Internationale Veröffentlichungsnummer: WO 2001/077008

(56) Entgegenhaltungen:
- EP-A- 0 890 998
- EP-A- 0 895 090
- WO-A-97/04319
- WO-A-98/23934
- DE-A- 19 700 290
- GENNISSEN P T J ET AL: "Bipolar-compatible epitaxial poly for smart sensors: Stress minimization and applications" SENSORS AND ACTUATORS A,CH,ELSEVIER SEQUOIA S.A., LAUSANNE, Bd. 62, Nr. 1-3, 1. Juli 1997 (1997-07-01), Seiten 636-645, XP004119702 ISSN: 0924-4247

## Beschreibung

### STAND DER TECHNIK

Die vorliegende Erfindung betrifft ein mikromechanisches Bauelement mit einem Substrat, einer auf dem Substrat vorgesehenen mikromechanischen Funktionsebene, einer auf der mikromechanischen Funktionsebene vorgesehenen Abdeckebene, und einer auf der Abdeckebene vorgesehenen Leiterbahnebene. Die vorliegende Erfindung betrifft ebenfalls ein entsprechendes Herstellungsverfahren.

Unter mikromechanische Funktion soll eine beliebige aktive Funktion, z.B. eine Sensorfunktion, oder passive Funktion, z.B. eine Leiterbahnfunktion, verstanden werden.

Obwohl auf beliebige mikromechanische Bauelemente und Strukturen, insbesondere Sensoren und Aktuatoren, anwendbar, werden die vorliegende Erfindung sowie die ihr zugrundeliegende Problematik in bezug auf ein in der Technologie der Silizium-Oberflächenmikromechanik herstellbares mikromechanisches Bauelement, z.B. einen Beschleunigungssensor, erläutert.

Allgemein bekannt sind monolithisch integrierte inertiale Sensoren in Oberflächenmikromechanik (OMM), bei denen die empfindlichen beweglichen Strukturen ungeschützt auf dem Chip aufgebracht sind (Analog Devices). Dadurch entsteht ein erhöhter Aufwand beim Handling und bei der Verpackung.

Umgehen kann man dieses Problem durch einen Sensor mit der Auswerteschaltung auf einem separaten Chip, z.B. werden dabei die OMM-Strukturen mittels einem zweiten Kappenwafer abgedeckt. Diese Art der Verpackung verursacht einen hohen Anteil der Kosten eines OMM-Beschleunigungssensors. Diese Kosten entstehen durch den hohen Flächenbedarf der Dichtfläche zwischen Kappenwafer und Sensorwafer und aufgrund der aufwendigen Strukturierung (2-3 Masken, Bulkmikromechanik) des Kappenwafers.

Die Auswerteschaltung wird auf einem zweiten Chip realisiert und mittels Drahtboden mit dem Sensorelement verbunden. Dadurch entsteht wiederum die Notwendigkeit die Sensorelemente so groß zu wählen, daß die parasitären Effekte, die durch die Parasiten in den Zuleitungen und Bondrähten entstehen, vernachlässigbar sind, daß sie keinen dominanten Einfluß auf die Sensorfunktion mehr haben. Außerdem verbieten sich wegen parasitärer Effekte Flipchiptechniken.

Solche Sensoren könnten mit wesentlich weniger Fläche für die Mikromechanik auskommen, wenn die Auswerteschaltung sich auf demselben Si-Chip befände und die empfindlichen Elektroden mit nur geringen Parasitäten angeschlossen werden können.

In der DE 195 37 814 A1 werden der Aufbau eines funktionalen Schichtsystems und ein Verfahren zur hermetischen Verkappung von Sensoren in Oberflächenmikromechanik beschrieben. Hierbei wird die Herstellung der Sensorstruktur mit bekannten technologischen Verfahren erläutert. Die besagte hermetische Verkappung erfolgt mit einem separaten Kappen-Wafer aus Silizium, der mit aufwendigen Strukturierungsprozessen, wie beispielsweise KHO-Ätzen, strukturiert wird. Der Kappen-Wafer wird mit einem Glas-Lot (Seal-Glas) auf dem Substrat mit dem Sensor (Sensor-Wafer) aufgebracht. Hierfür ist um jeden Sensorchip ein breiter Bond-Rahmen notwendig, um eine ausreichende Haftung und Dichtheit der Kappe zu gewährleisten. Dies begrenzt die Anzahl der Sensor-Chips pro Sensor-Wafer erheblich. Auf Grund des großen Platzbedarfs und der aufwendigen Herstellung des KappenWafers entfallen erhebliche Kosten auf die Sensor-Verkappung.

Die DE 43 41 271 A1 offenbart einen mikromechanischen Beschleunigungssensor, dessen Bestandteile zum Teil aus monokristallinem Material und zum Teil aus polykristallinem Material bestehen. Zur Herstellung dieses bekannten mikromechanischen Beschleunigungssensors wird ein Epitaxie-Reaktor verwendet. Eine Startschicht aus LPCVD-Polysilizium dient zur Festlegung der Bereiche, wo beim Epitaxie-Prozeß polykristallines Silizium aufwachsen soll.

XP4119702 von Gennissen et al. offenbart ein mikromechanisches Bauelement, dessen Bestandteile zum Teil aus monokristallinem Material und zum Teil aus polykristallinem Material bestehen. Zur Herstellung dieses bekannten mikromechanischen Bauelementes wird ein Epitaxie-Verfahren verwendet. Eine Startschicht aus LPCVD-Polysilizium dient zur Festlegung der Bereiche, wo beim Epitaxie-Verfahren polykristallines Silizium aufwachsen soll.

### VORTEILE DER ERFINDUNG

Das erfindungsgemäße mikromechanische Bauelement mit den Merkmalen des Anspruchs 1 bzw. das Herstellungsverfahren nach Anspruch 9 weisen folgende Vorteile auf. Eine monolithische Integration der Auswerteschaltung und des Sensorelements auf einem Chip ist möglich. Fehlerträchtige aufwendige Bonddrähte zwischen Sensorelement und Auswerteschaltung können entfallen. Eine Reduktion der Größe der Sensierelemente ist möglich, da weniger parasitäre Effekte in der Kontaktierung auftreten. Es muß nur noch ein Chip montiert werden. Der Prozeß baut auf den aus der P4318466.9 bekannten OMM-Prozeß auf, der Epitaxie-Polysilizium mit mindestens 10 µm Dicke liefert. Es ergibt sich eine Vereinfachung des OMM-Prozesses, da die Strukturen von oben kontaktiert werden können. Ein Entfallen des vergrabenen Polysiliziums ist möglich.

Die Integration des Bauelementes ist weitestgehend unabhängig vom Prozeß der Auswerteschaltung, wodurch eine Anpassung an neue IC-Prozesse vereinfacht wird. Das Bauelement kann je nach Sensorprinzip auf die Größe der bisher benötigten Bondpads auf dem IC zur Kontaktierung reduziert werden, wodurch die Kosten des IC's aufgrund von zusätzlicher Fläche nicht steigen.

Nach der Erfindung ist es möglich, den Sensorchip im sogenannten Flip-Chipverfahren, also kopfüber mit eutektischen oder Goldbumps anstelle mit Bonddrähten anzuschließen, da die parasitären Einflüsse gegenüber der Zwei-Chip-Lösung stark reduziert werden. Mit dieser Technik lassen sich auch Sensoren mit CSP (chip scale package) darstellen, bei denen die Verpackung nicht mehr als 20% größer als der Chip ist. Ein CSP-verpackter Chip kann vor der Montage vorgemessen und abgeglichen werden.

Kern der Erfindung ist die Kombination des einkristallinen und polykristallinen Wachstums während der Abscheidung der Abdeckschicht im Epi-Reaktor. Einkristallines Silizium benötigt dabei eine einkristalline Oberfläche als Ausgangsschicht, polykristallines Silizium eine polykristalline Startschicht, welche vorzugsweise durch LPCVD abgeschieden wird.

In den Unteransprüchen finden sich vorteilhafte Weiterbildungen und Verbesserungen des jeweiligen Gegenstandes der Erfindung.

Gemäß einer bevorzugten Weiterbildung weist eine erste Schicht mit der mikromechanischen Funktionsebene einen monokristallinen Bereich auf, der epitaktisch auf einem darunterliegenden monokristallinen Bereich aufgewachsen ist, sowie einen polykristallinen Bereich, der gleichzeitig epitaktisch auf einer darunterliegenden polykristallinen Startschicht aufgewachsen ist. Damit wird zweimal derselbe Epitaxieschritt in zwei verschiedenen Ebenen angewendet. Gemäß einer weiteren bevorzugten Weiterbildung weist eine erste Schicht mit der mikromechanischen Funktionsebene einen monokristallinen Bereich auf, der über eine Isolatorschicht in SOI-Form mit dem Substrat gebildet ist. Dies hat den Vorteil, daß die vergrabene Polysiliziumschicht weggelassen werden kann und ein Epitaxieschritt entfällt. Als Silizium wird vorzugsweise einkristallines, hochdotiertes und mechanisch spannungsfreies Grundmaterial verwendet.

Gemäß einer weiteren bevorzugten Weiterbildung enthält der monokristalline Bereich eine zweite Schicht, die über der ersten Schicht abgeschieden wird, mit ein oder mehreren integrierte Schaltungselementen einer Auswerteschaltung oder Verdrahtungselemente. Damit läßt sich eine sogenannte monolithisch integrierte Ein-Chip-Lösung erreichen.

Gemäß einer weiteren bevorzugten Weiterbildung weist der polykristalline Bereich der mikromechanischen Funktionsebene eine bewegliche Sensorstruktur auf.

Gemäß einer weiteren bevorzugten Weiterbildung weist die mikromechanische Funktionsebene eine vergrabene Polysiliziumschicht unterhalb der beweglichen Sensorstruktur auf.

Gemäß einer weiteren bevorzugten Weiterbildung sind in der Leiterbahnebene ein oder mehrere Flip-Chip-Anschlußelemente, vorzugsweise Gold-Bumps, vorgesehen. Dies ist eine robuste Art der Kontaktierung, die durch die im wesentlichen planare Oberfläche möglich wird.

Gemäß einer weiteren bevorzugten Weiterbildung ist das Bauelement in Silizium-Oberflächenmikromechanik herstellbar.

### ZEICHNUNGEN

Ausführungsbeispiele der Erfindung sind in den Zeichnungen dargestellt und in der nachfolgenden Beschreibung näher erläutert.

Es zeigen:
- Fig. 1: eine schematische Querschnittsansicht eines mikromechanischen Bauelements gemäß einer ersten Ausführungsform der vorliegenden Erfindung;
- Fig. 2a,b: eine schematische Querschnittsansicht der Herstellungschritte des mikromechanischen Bauelements gemäß Fig. 1; und
- Fig. 3: eine schematische Querschnittsansicht eines mikromechanischen Bauelements gemäß einer zweiten Ausführungsform der vorliegenden Erfindung.

### BESCHREIBUNG DER AUSFÜHRUNGSBEISPIELE

In den Figuren bezeichnen gleiche Bezugszeichen gleiche oder funktionsgleiche Komponenten.

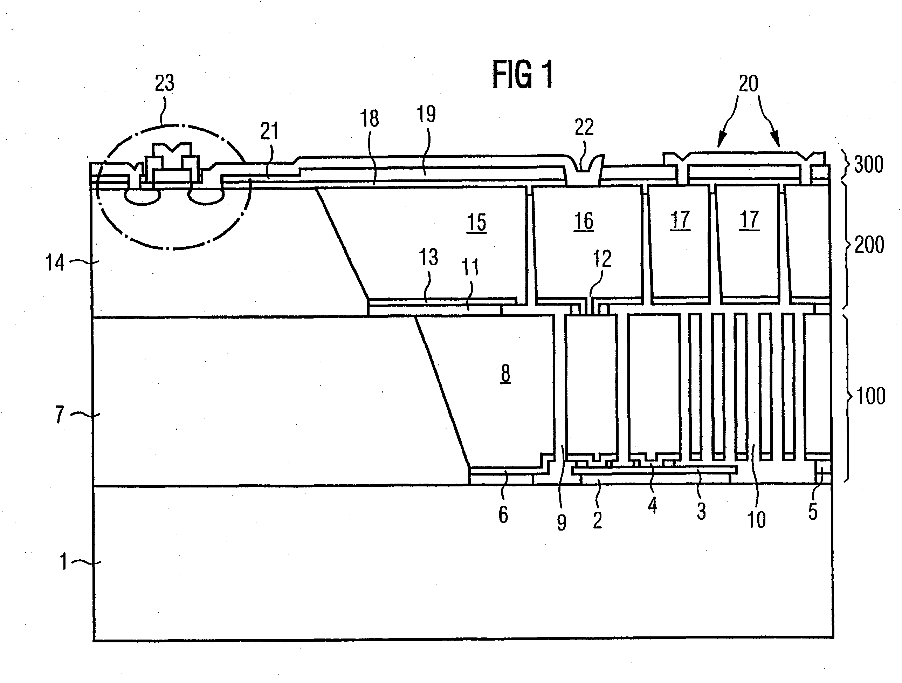

Fig. 1 ist eine schematische Querschnittsansicht eines mikromechanischen Bauelements gemäß einer ersten Ausführungsform der vorliegenden Erfindung.

In Fig. 1 bezeichnen 1 einen Silizium-Substratwafer, 2 ein unteres Oxid, 3 vergrabenes Polysilizium, 4 ein Kontaktloch im Opferoxid 5, 5 ein Opferoxid, 6 ein erstes Start-Polysilizium, 7 ein erstes einkristallines Silizium aus Epitaxie, 8 ein erstes Epitaxie-Polysilizium, 9 einen Isolationsgraben, 10 eine bewegliche Sensorstruktur, 11 ein erstes Refilloxid, 12 ein Kontaktloch im Refifilloxid 11, 13 ein zweites Start-Polysilizium, 14 ein zweites einkristallines Silizium aus Epitaxie, 15 ein zweites Epitaxie-Polysilizium, 16 ein elektrisches und/oder mechanisches Verbindungselement zwischen erstem und zweiten Epitaxie-Polysilizium, 17 einen Trenchgraben, 18 ein zweites Refilloxid, 19 ein Oxid zur Isolation der Leiterbahnen, 20 eine Überkreuzverbindung, 21 eine Leiterbahn, 22 ein Kontaktloch in der Leiterbahn 21 und dem Refilloxid 18 und 23 ein elektronisches Bauelement der Auswerteschaltung.

100 bezeichnet eine mikromechanische Funktionsebene mit der beweglichen Sensorstruktur 10 - hier ein Beschleunigungssensor -, 200 eine Abdeckebene zur hermetischen Versiegelung der beweglichen Sensorstruktur 10 und 300 eine Leiterbahnebene.

Bei dieser ersten Ausführungsform, die in an sich bekannter Silizium-Oberflächenmikromechanik herstellbar ist, weist einerseits die Abdeckebene 200 den monokristallinen Bereich 14 aufweist, der epitaktisch auf dem darunterliegenden monokristallinen Bereich 7 aufgewachsen ist. Andererseits weist die Abdeckebene 200 den polykristallinen Bereich 15 aufweist, der gleichzeitig epitaktisch auf der darunterliegenden polykristallinen Startschicht 13 aufgewachsen ist. Mit anderen Worten werden in einem Prozeßschritt monokristallines und polykristallines Silizium nebeneinander aufgewachsen.

Der monokristalline Bereich 14 der Abdeckebene 200 enthält integrierte Schaltungselemente einer Auswerteschaltung. Illustriert ist als Beispiel ein CMOS-Transistor 23.

Analog dazu weist die mikromechanische Funktionsebene 100 den monokristallinen Bereich 7 aufweist, der epitaktisch auf dem darunterliegenden monokristallinen Substratbereich 1 aufgewachsen ist, sowie den polykristallinen Bereich 8, der gleichzeitig epitaktisch auf der darunterliegenden polykristallinen Startschicht 6 aufgewachsen ist. Dieser Prozeßschritt des simultan ein- und polykristallin aufwachsenden Si wird also sowohl für die Sensorstruktur 10 als auch für die Abdeckebene 200 durchgeführt.

Die mikromechanische Funktionsebene 100 weist die vergrabene Polysiliziumschicht 3 unterhalb der beweglichen Sensorstruktur 10 als Verdrahtungsebene auf.

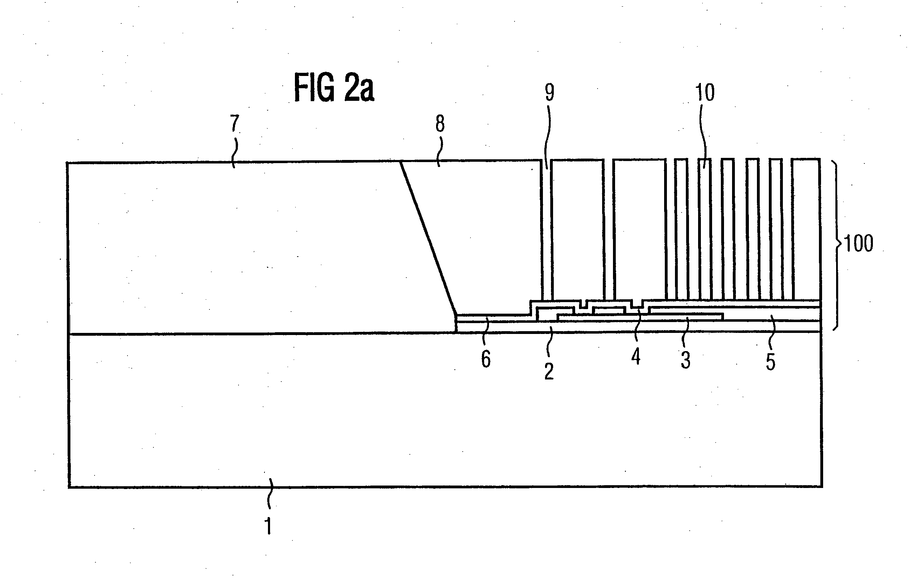

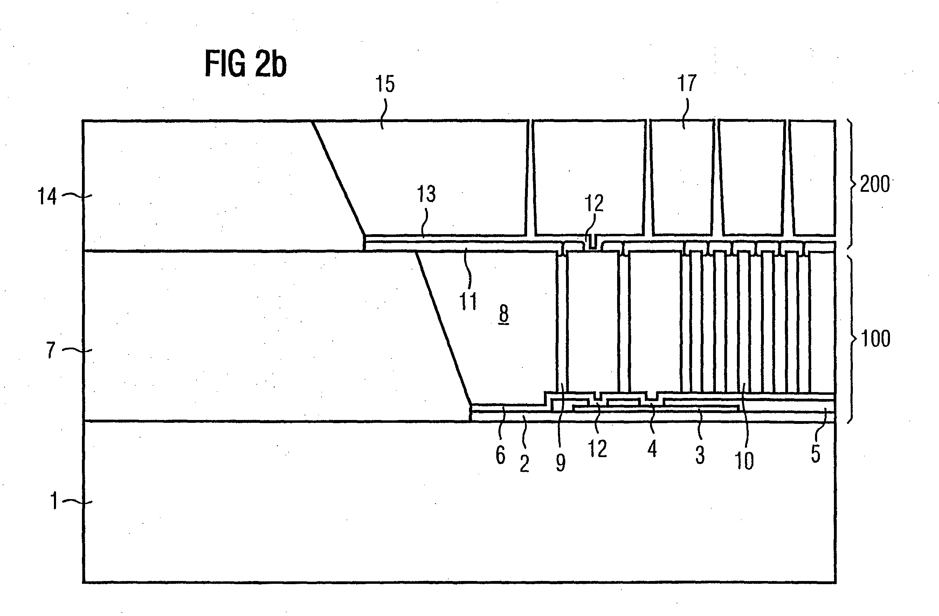

Fig. 2a,b zeigen eine schematische Querschnittsansicht der Herstellungschritte des mikromechanischen Bauelements gemäß Fig. 1.

IC-Prozesse benötigen im allgemeinen ein einkristallines Si-Substrat 1 als Ausgangsmaterial für den Prozeß. Das gilt sowohl für Prozesse mit analogen Bauelementen, die eine epitaktisch abgeschiedene einkristalline Si-Schicht benötigen, als auch für reine CMOS-Prozesse, die keine Epitaxie benötigen. Also wird bei diesem Beispiel mit einem einkristallinen Si-Wafer als Substrat 1 gestartet.

In einem ersten Schritt erfolgt eine Oxidation des Substrats 1 zur Bildung des unteren Oxids 2. Anschließend erfolgt eine Abscheidung und Strukturierung des vergrabenen Polysiliziums 3 als unterer Leiterbahnbereich. In einem folgenden Schritt wird das Opferoxid 5 abgeschieden und strukturiert. Danach erfolgt eine Abscheidung und Strukturierung des ersten Start-Polysiliziums 6, insbesondere ein entfernen des Start-Polysiliziums und des unteren Oxids 2 an Stellen, wo im späteren Epitaxieschritt einkristallines Silizium (Bereich 7 in Fig. 2a) auf dem Substrat 1 aufwachsen soll.

Danach erfolgt der Epitaxie-Schritt, in dem der monokristalline Siliziumbereich 7 zusammen mit dem polykristallinen Siliziumbereich 8 der mikromechanischen Funktionsebene 100 aufgewachsen werden. Ein weiterer Schritt ist eine optionale Planarisierung der resultierenden Struktur zum Ausgleich von geringfügigen Höhenunterschieden aufgrund des Unterbaus, der zwischen dem Substrat 1 und dem polykristallinen Siliziumbereich 8 liegt.

Wie in Figur 2b illustriert, erfolgt dann ein Refill mit dem Refilloxid 11 und eine Strukturierung des Refilloxids 11 zur Bildung von Kontaktlöchern 12. Als nächstes wird die zweite Start-Polysiliziumschicht 13 abgeschieden und zusammen mit dem ersten Refilloxid 11 strukturiert, insbesondere werden das zweite Start-Polysilizium 13 und das Refilloxid 11 dort entfernt, wo einkristallines Silizium (Bereich 14 in Fig. 2b) auf dem Bereich 7 aufwachsen soll. In einem darauffolgenden Prozeßschritt folgt der zweite Epitaxieprozess, in dem gleichzeitig monokristallines Silizium im Bereich 14 und polykristallines Silizium im Bereich 15 abgeschieden werden. Wiederum optional folgt eine Planarisierung der resultierenden Deckschicht zum Ausgleich des Unterbaus zwischen dem Polysiliziumbereich 8 und dem Polysiliziumbereich 15.

Als nächstes werden die Trenchgräben 17 im zweiten Epitaxie-Polysilizium 15 gebildet, welche zur Isolation und als Ätzlöcher zum Entfernen des ersten Refilloxids 11 dienen. Das Ätzprofil der Trenchgräben 17 kann so gewählt werden, daß sie sich nach unten hin auch aufweiten, wie in Figur 2b angedeutet. Der obere Öffnungsdurchmesser sollte minimal gewählt werden, damit die Abscheidung des zweiten Refilloxids 18 schneller bewerkstelligt werden kann, und zwar ohne daß eine wesentliche Menge des zweiten Refilloxids 18 in die bewegliche Sensorstruktur 10 gelangt. Gewünscht ist also eine anisotrope Oxidabscheidung, und zwar möglichst nur auf der Oberfläche.

In einem folgenden Prozeßschritt erfolgt das Freiätzen der beweglichen Sensorstruktur 10 durch Entfernen des unteren Oxids 2, des Opferoxids 5 und des ersten Refilloxids 11 durch die Ätzgräben 17. Man könnte das Freiätzen zur besseren Kontrolle auch in zwei Schritte aufteilen, in dem man vor der Abscheidung des ersten Refilloxids 11 die unteren Oxide 2 und 5 entfernt und dann erst das erste Refilloxid 11 abscheidet. Ein wesentlicher Vorteil dieses Prozesses liegt darin, das beim Opferschichtätzen, was derzeit mit HF-Dampf erfolgt, noch keine elektronische Schaltung und Aluminium vorhanden sind, was bei dem Back-End-Prozessen nur sehr schwer und aufwendig geschützt werden kann.

Im nächsten Schritt erfolgt eine Abscheidung und Strukturierung des zweiten Refilloxids 18, die Einstellung eines vorbestimmten Drucks und einer vorbestimmten Gasatmosphäre beim entgültigen Verschließen der Hohlräume durch das zweite Refilloxid 18, was die Eigenschaften des eingeschlossenen Gases somit unter anderem die Dämpfung der mechanischen Sensorstruktur 10 bestimmt.

Nachdem das mikromechanische Bauelement fertiggestellt ist, kann nunmehr der IC-Prozeß, z.B. ein CMOS- oder BiCMOS-Prozess, zur Herstellung der Auswerteschaltung im monokristallinen Siliziumbereich 14 erfolgen. Danach erfolgt eine Abscheidung und Strukturierung der Leiterbahnebene 300, insbesondere des Oxids 19 und des Leiterbahn-Aluminiums 21. Zur Fertigstellung des Bauelements erfolgt üblicherweise ein Zersägen der Chips und eine Montage wie bei den Standard-IC-Bauele-menten.

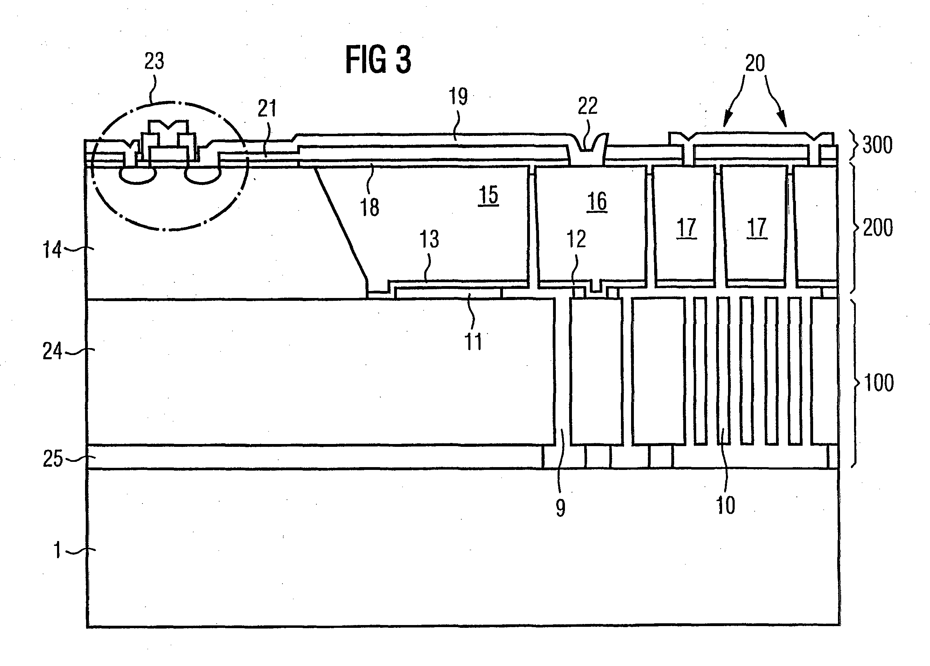

Fig. 3 ist eine schematische Querschnittsansicht eines mikromechanischen Bauelements gemäß einer zweiten Ausführungsform der vorliegenden Erfindung.

In Fig. 3 bezeichnen zusätzlich zu den bereits eingeführten Bezugszeichen 24 eine SOI(Silicon on Insulator)-Schicht und 25 eine Isolator(Insulator)-Schicht. Bei dieser zweiten Ausführungsform bilden also das Substrat 1, die Isolatorschicht 25 und die monokristalline Siliziumschicht 24 eine an sich bekannte SOI-Struktur.

Bei dem derart aufgebauten Bauelement sind das untere Oxid 2, das vergrabene Polysilizium 3, das Kontaktloch 4 im Opferoxid 5, das Opferoxid 5, das erste Start-Polysilizium 6, das erste einkristalline Silizium aus Epitaxie 7 und das erste Epitaxie-Polysilizium 8 weggelassen.

Benutzt man ein also solch einen SOI-Wafer als Ausgangsmaterial, entfallen also zahlreiche Prozeßschritte, da dann die mechanisch aktive Struktur aus dem SOI-Material 24 gebildet wird. Die gesamte Verdrahtung wird also bei dieser zweiten Ausführungsform in die Leiterbahnebene 300 verlegt. Obwohl die vorliegende Erfindung vorstehend anhand eines bevorzugten Ausführungsbeispiels beschrieben wurde, ist sie darauf nicht beschränkt, sondern auf vielfältige Weise modifizierbar.

Es können insbesondere beliebige mikromechanische Grundmaterialien, wie z.B. Germanium, verwendet werden, und nicht nur das exemplarisch angeführte Siliziumsubstrat.

Auch können beliebige Sensorstrukturen gebildet werden, und nicht nur der illustrierte Beschleunigungssensor.

Der Bereich 15 muß nicht unbedingt polykristallin sein, sondern kann rekristallisiert sein o.ä..

## Patentansprüche

1. Mikromechanisches Bauelement mit einem Substrat (1); einer auf dem Substrat vorgesehenen mikromechanischen Funktionsebene (100); einer auf der mikromechanischen Funktionsebene (100) vorgesehenen Abdeckebene (200); und einer auf der Abdeckebene (200) vorgesehenen Leiterbahnebene (300); wobei die Abdeckebene (200) einen monokristallinen Bereich (14) aufweist, der epitaktisch auf einem darunter liegenden monokristallinen Bereich (7; 24) der mikromechanischen Funktionsebene (100) aufgewachsen ist; und die Abdeckebene (200) einen polykristallinen Bereich (15) aufweist, der gleichzeitig epitaktisch auf einer darunter liegenden polykristallinen Startschicht (13) aufgewachsen ist.

2. Mikromechanisches Bauelement nach Anspruch 1, **dadurch gekennzeichnet, daß** die mikromechanische Funktionsebene (100) einen monokristallinen Bereich (7) aufweist, der epitaktisch auf einem darunterliegenden monokristallinen Bereich (1) aufgewachsen ist, sowie einen polykristallinen Bereich (8) aufweist, der gleichzeitig epitaktisch auf einer darunterliegenden polykristallinen Startschicht (6) aufgewachsen ist.

3. Mikromechanisches Bauelement nach Anspruch 1, **dadurch gekennzeichnet, daß** die mikromechanische Funktionsebene (100) einen monokristallinen Bereich (24) aufweist, der über eine Isolatorschicht (25) in SOI-Form mit dem Substrat (1) gebildet ist.

4. Mikromechanisches Bauelement nach Anspruch 1, 2 oder 3, **dadurch gekennzeichnet, daß** der monokristalline Bereich (14) der Abdeckebene (200) ein oder mehrere integrierte Schaltungselemente (23) einer Auswerteschaltung oder Verdrahtungselemente enthält.

5. Mikromechanisches Bauelement nach einem der vorhergehenden Ansprüche, **dadurch gekennzeichnet, daß** der polykristalline Bereich (8) der mikromechanischen Funktionsebene (100) eine bewegliche Sensorstruktur (10) aufweist.

6. Mikromechanisches Bauelement Anspruch 5, **dadurch gekennzeichnet, daß** die mikromechanische Funktionsebene (100) eine vergrabene Polysiliziumschicht (3) unterhalb der beweglichen Sensorstruktur (10) aufweist.

7. Mikromechanisches Bauelement nach einem der vorhergehenden Ansprüche, **dadurch gekennzeichnet, daß** in der Leiterbahnebene (300) ein oder mehrere Flip-Chip-Anschlußelemente, vorzugsweise Gold-Bumps, vorgesehen sind.

8. Mikromechanisches Bauelement nach einem der vorhergehenden Ansprüche, **dadurch gekennzeichnet, daß** es in Silizium-Oberflächenmikromechanik herstellbar ist.

9. Verfahren zur Herstellung eines mikromechanischen Bauelementes mit den Schritten:
Bereitstellen eines Substrats (1);
Vorsehen einer mikromechanischen Funktionsebene (100) auf dem Substrat (1);
Vorsehen einer Abdeckebene (200) auf der mikromechanischen Funktionsebene (100);
dabei bereichsweises Vorsehen einer Polysilizium-Startschicht (13) auf der mikromechanischen Funktionsebene (100) und bereichsweises Freilassen von einem monokristallinen Bereich (7, 24) der mikromechanischen Funktionsebene (100); epitaktisches Abscheiden eines monokristallinen Bereichs (14) auf dem freigelassenen monokristallinen Bereich (7, 24) und gleichzeitiges epitaktisches Abscheiden eines pölykristallinen Bereichs (15) auf der polykristallinen Startschicht (13); und
Vorsehen einer Leiterbahnebene (300) auf der Abdeckebene (200).

## Claims

1. Micromechanical component comprising a substrate (1); a micromechanical functional plane (100) provided on the substrate; a covering plane (200) provided on the micromechanical functional plane (100); and a conductor track plane (300) provided on the covering plane (200); wherein the covering plane (200) has a monocrystalline region (14), which is grown epitaxially on an underlying monocrystalline region (7; 24) of the micromechanical functional plane (100); and the covering plane (200) has a polycrystalline region (15), which is simultaneously grown epitaxially on an underlying polycrystalline start layer (13).

2. Micromechanical component according to Claim 1, **characterized in that** the micromechanical functional plane (100) has a monocrystalline region (7), which is grown epitaxially on an underlying monocrystalline region (1), and also has a polycrystalline region (8), which is simultaneously grown epitaxially on an underlying polycrystalline start layer (6).

3. Micromechanical component according to Claim 1, **characterized in that** the micromechanical functional plane (100) has a monocrystalline region (24), which is formed above an insulator layer (25) in SOI form with the substrate (1).

4. Micromechanical component according to Claim 1, 2 or 3, **characterized in that** the monocrystalline region (14) of the covering plane (200) contains one or a plurality of integrated circuit elements (23) of an evaluation circuit or wiring elements.

5. Micromechanical component according to any of the preceding claims, **characterized in that** the polycrystalline region (8) of the micromechanical functional plane (100) has a movable sensor structure (10).

6. Micromechanical component according to Claim 5, **characterized in that** the micromechanical functional plane (100) has a buried polysilicon layer (3) below the movable sensor structure (10).

7. Micromechanical component according to any of the preceding claims, **characterized in that** one or a plurality of flip-chip connection elements, preferably gold bumps, are provided in the conductor track plane (300).

8. Micromechanical component according to any of the preceding claims, **characterized in that** it is producible using silicon surface micromachining.

9. Method for producing a micromechanical component comprising the following steps:
providing a substrate (1);
providing a micromechanical functional plane (100) on the substrate (1);
providing a covering plane (200) on the micromechanical functional plane (100);
in the process regionally providing a polysilicon start layer (13) on the micromechanical functional plane (100) and regionally leaving free a monocrystalline region (7, 24) of the micromechanical functional plane (100); epitaxially depositing a monocrystalline region (14) on the monocrystalline region (7, 24) left free and simultaneously epitaxially depositing a polycrystalline region (15) on the polycrystalline start layer (13); and
providing a conductor track plane (300) on the covering plane (200).

## Revendications

1. Composant micromécanique présentant
un substrat (1),
un niveau (100) à fonction micromécanique prévu sur le substrat,
un niveau de recouvrement (200) prévu sur le niveau (100) à fonction micromécanique et
un niveau (300) de pistes conductrices prévu sur le niveau de recouvrement (200),
le niveau de recouvrement (200) présentant une partie monocristalline (14) obtenue par croissance épitaxique sur une partie monocristalline sous-jacente (7; 24) du niveau (100) à fonction micromécanique,
le niveau de recouvrement (200) présentant une partie polycristalline (15) obtenue par croissance épitaxique simultanée sur une couche polycristalline sous-jacente de départ (13).

2. Composant micromécanique selon la revendication 1, **caractérisé en ce que** le niveau (100) à fonction micromécanique présente une partie monocristalline (7) obtenue par croissance épitaxique sur une partie monocristalline sous-jacente (1) ainsi qu'une partie polycristalline (8) obtenue par croissance épitaxique simultanée sur une couche polycristalline sous-jacente de départ (6).

3. Composant micromécanique selon la revendication 1, **caractérisé en ce que** le niveau (100) à fonction micromécanique présente une partie monocristalline (24) formée au-dessus d'une couche isolante (25) de forme SOI avec le substrat (1).

4. Composant micromécanique selon les revendications 1, 2 ou 3, **caractérisé en ce que** la partie monocristalline (14) du niveau de recouvrement (200) contient un ou plusieurs éléments (23) de circuit intégré d'un circuit d'évaluation ou des éléments de câblage.

5. Composant micromécanique selon l'une des revendications précédentes, **caractérisé en ce que** la partie polycristalline (8) du niveau (100) à fonction micromécanique présente une structure mobile de capteur (10).

6. Composant micromécanique selon la revendication 5, **caractérisé en ce que** le niveau (100) à fonction micromécanique présente une couche (3) de polysilicium creusée en dessous de la structure mobile de capteur (10).

7. Composant micromécanique selon l'une des revendications précédentes, **caractérisé en ce qu'**un ou plusieurs éléments de raccordement "flip-chip", de préférence des boutons d'or, sont prévus dans le niveau (300) de pistes conductrices.

8. Composant micromécanique selon l'une des revendications précédentes, **caractérisé en ce qu'**il peut être fabriqué par micromécanique de surface en silicium.

9. Procédé de fabrication d'un composant micromécanique, le procédé présentant les étapes qui consistent à :
préparer un substrat (1),
prévoir un niveau (100) à fonction micromécanique sur le substrat (1),
prévoir un niveau de recouvrement (200) sur le niveau (100) à fonction micromécanique,
prévoir une couche de départ (13) en polysilicium dans certaines parties du niveau (100) à fonction micromécanique et libération de certaines parties d'une partie monocristalline (7, 24) du niveau (100) à fonction micromécanique,
déposer par épitaxie une partie monocristalline (14) sur la partie monocristalline (7, 24) libérée et en même temps déposer par épitaxie une partie polycristalline (15) sur la couche polycristalline de départ (13) et
prévoir un niveau (300) de pistes conductrices sur le niveau de recouvrement (200).
